# FASCICULE DE BREVET EUROPEEN

(11) **EP 3 275 292 B1**
(45) Date de publication et mention de la délivrance du brevet: **02.03.2022**
(21) Numéro de dépôt: 16714805.5
(22) Date de dépôt: 23.03.2016
(51) Int. Cl.: H05K 7/14, H05K 1/11, H05K 3/42, H05K 3/00

(54) **CARTE ÉLECTRONIQUE DE FOND DE PANIER ET CALCULATEUR ÉLECTRONIQUE ASSOCIÉ**
RÜCKWANDLEITERPLATTE UND ENTSPRECHENDE ELEKTRONISCHE STEUEREINHEIT
BACKPLANE ELECTRONIC BOARD AND ASSOCIATED ELECTRONIC CONTROL UNIT

(30) Priorité: 23.03.2015 FR 1552398
(43) Date de publication de la demande: 31.01.2018
(73) Titulaire: Safran Electronics & Defense, 92100 Boulogne-Billancourt (FR)
(72) Inventeur: GUILLOT, François, 92100 Boulogne-Billancourt (FR); SPOOR, Pascal, 92100 Boulogne-Billancourt (FR); CHETANNEAU, Patrice, 92100 Boulogne-Billancourt (FR)
(74) Mandataire: Regimbeau
(86) Numéro de dépôt international: PCT/EP2016/056462
(87) Numéro de publication internationale: WO 2016/151053

(56) Documents cités:
- US-A1- 2003 179 532
- US-A1- 2005 109 532
- US-A1- 2008 257 594
- US-A1- 2014 353 018

## Description

### DOMAINE DE L'INVENTION

Le domaine de l'invention est celui des calculateurs électroniques et en particulier les calculateurs des systèmes embarqués en avionique.

### ETAT DE LA TECHNIQUE

Dans les avions modernes, il est connu de relier entre eux les modules de pilotage et/ou de contrôle d'organes fonctionnels de l'avion au travers d'un ou plusieurs bus principaux de l'avion. Ces bus sont couramment des bus spécifiques au domaine de l'aviation, et notamment des bus utilisant les protocoles de bus série distribués de types ARINC 429 ou autres. Ainsi, à titre d'exemple, pour la gestion des éléments mobiles des trains d'atterrissage d'un avion, plusieurs modules de pilotage et/ou de contrôle sont mis en œuvre, ces derniers étant chacun reliés aux bus principaux de l'avion.

Chaque module de pilotage comporte un calculateur 1 mettant en œuvre un programme adapté afin d'assurer la fonction de pilotage auquel il est dédié, ainsi qu'une interface de communication adaptée au protocole du bus principal permettant l'échange de données entre le calculateur et les bus principaux de l'avion.

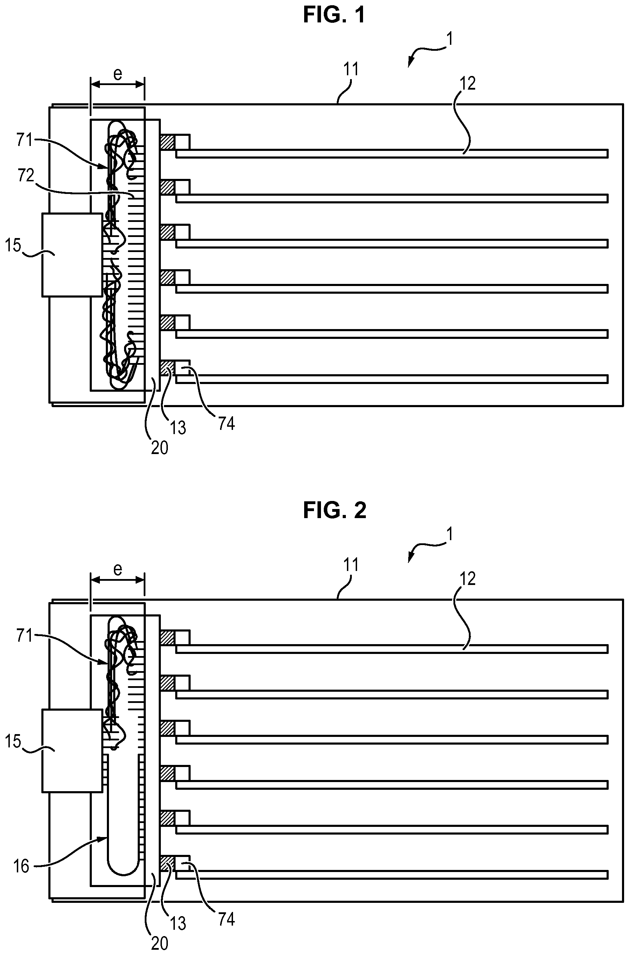

La figure 1 montre le schéma simplifié d'un calculateur électronique 1. Celui-ci comprend un bâti mécanique 11, une ou plusieurs cartes électroniques 12 et une carte 20 dite carte de 'fond de panier' ou 'backplane' en anglais.

Chaque carte électronique 12 est maintenue mécaniquement dans le bâti 11 par des glissières et connectée à la carte de 'fond de panier' 20. La carte de 'fond de panier' 20 comporte des connecteurs de carte 13 adaptés pour être connectés à un connecteur complémentaire 74 porté par la carte électronique 12.

La carte de fond de panier 20 comporte pour chaque module de pilotage, un connecteur externe 15 adapté pour coopérer avec un connecteur complémentaire porté par le module associé.

Comme illustré sur la figure 1, il est connu de connecter le connecteur externe 15 à la carte de fond de panier 20 par des fils 71 enroulés sur des broches carrés 72 des composants, selon la méthode dite de 'Wrapping' selon la terminologie anglo-saxonne.

La technique de wrapping présente de nombreux inconvénients et notamment un prix de revient excessif, l'obsolescence des composants et des compétences et de médiocres performances de compatibilité électromagnétique.

Un autre inconvénient du wrapping est que l'absence d'adaptation d'impédance et le bruit peuvent générer des phénomènes de réflexion aux fréquences élevées et des défaillances électroniques sur les signaux critiques.

Un autre inconvénient du wrapping est qu'il nécessite une zone de câblage de largeur conséquente qui pénalise la compacité du calculateur 1.

Comme illustré sur la figure 2, il a été proposé d'utiliser une nappe 16 qui est une bande électrique plate (circuit imprimé flexible en nappe), constituée de fils de cuivre collés les uns aux autres, munie d'un connecteur à chacune de ses extrémités pour relier le connecteur externe 15 et la carte de fond de panier 20.

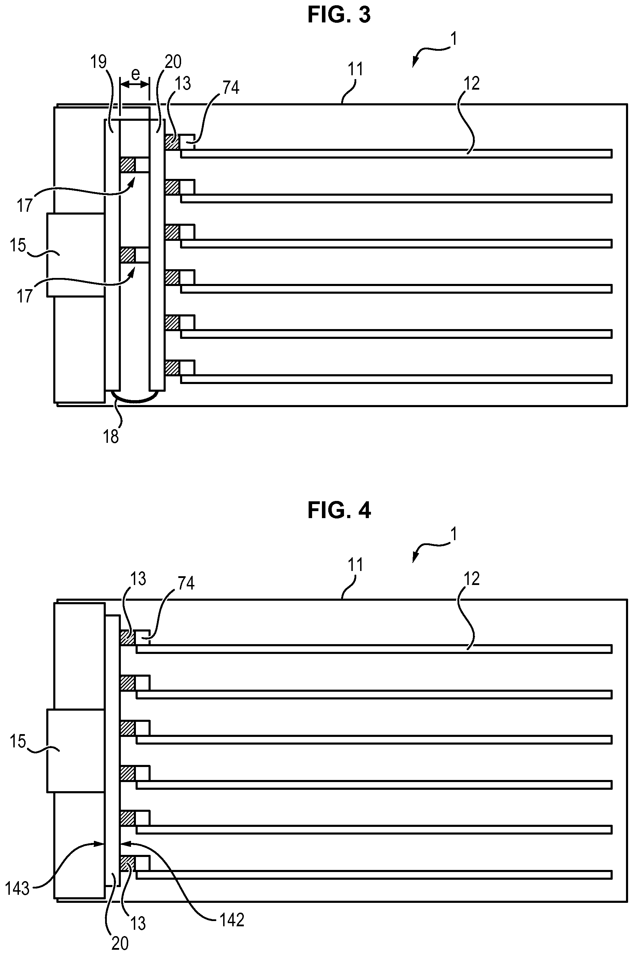

Comme illustré sur la figure 3, il a également été proposé de connecter le connecteur externe 15 à un circuit imprimé de raccordement 19 connecté à la carte de fond de panier 20 par l'intermédiaire d'un circuit imprimé flexible 18 et de connecteurs d'interconnexions complémentaires 17.

Toutes ces solutions sont complexes, coûteuses et encombrantes.

On connait par ailleurs des cartes électroniques, comme celle décrite dans le document US 2005/109532 A1, comportant deux circuits imprimés collés l'un à l'autre par une couche de résine et présentant une série de premiers trous borgnes débouchant sur la première face de la carte électronique et une série de seconds trous borgnes débouchant sur la seconde face de la carte électronique permettant l'accueil direct de connecteurs utilisant une technologie de broches montées en forces dans des trous métallisés et étant montés directement de part et d'autre de chaque face de PCB.

Or, dans de telles cartes électroniques, la résine risque de remonter dans les trous borgnes lors de l'assemblage des circuits imprimés, ce qui a pour conséquence que les éléments de connexion en forme de broche ne peuvent plus être insérés dans les trous borgnes.

L'état de l'art comprend aussi le document US-A1-2014/353018.

### EXPOSE DE L'INVENTION

L'invention permet de pallier au moins un des inconvénients précités en proposant une carte électronique de fond de panier selon la revendication

Les premières et secondes membranes étanches empêchent la remontée de la résine dans les trous borgnes lors de la fabrication de la carte de fond de panier.

L'invention permet de supprimer l'intégralité des câblages filaires et des nappes dans le bloc arrière.

L'invention permet en outre de supprimer tous les composants montés directement sur le bâti mécanique ainsi que toutes cartes additionnelles (autres que les cartes électroniques).

L'invention permet de réduire l'espace de connexion entre le connecteur externe et les cartes électroniques. La profondeur des calculateurs étant fixée dans l'avionique, cela permet concrètement d'augmenter la longueur des cartes électroniques.

L'invention permet également l'allocation de fonctions de filtrage sur le circuit imprimé principal du bloc fond notamment ce qui permet la suppression des cartes et des filtres additionnels.

L'invention est avantageusement complétée par les caractéristiques suivantes, prises individuellement ou en l'une quelconque de leurs combinaisons techniquement possibles.

Les trous borgnes sont ménagés dans la carte électronique de fond de panier de manière à ménager entre eux une zone de blindage.

La carte de fond de panier possède en outre des trous traversants qui traversent la carte de fond de panier de part et d'autre.

La carte de fond de panier comporte un circuit imprimé principal comportant deux circuits imprimés multicouches, deux couches isolantes, et un circuit imprimé double faces disposé au milieu des deux couches isolantes, elles-mêmes disposées au milieu des deux circuits imprimés multicouches, le circuit imprimé double faces constituant la zone de blindage.

La carte de fond de panier comporte une couche de polymère isolant entre le circuit imprimé multicouche et la couche isolante.

La carte de fond de panier comporte un circuit imprimé principal et une plaquette d'interface fixée sur le circuit imprimé principal, la plaquette d'interface présentant des trous adaptés pour recevoir des éléments de connexion à insertion par force et former avec eux un point de connexion électrique.

La plaquette d'interface comporte une matrice de billes adaptée pour être soudée sur le circuit imprimé principal.

Les premiers trous borgnes sont avantageusement recouverts d'une couche externe de polymère isolant destinée à être percée par des éléments de connexion à insertion par force.

L'invention propose également un calculateur électronique selon la revendication 9.

L'invention propose aussi un procédé de fabrication d'une carte électronique selon la revendication 10.

### DESCRIPTION DES FIGURES

D'autres objectifs, caractéristiques et avantages sortiront de la description détaillée qui suit en référence aux dessins donnés à titre illustratif et non limitatif parmi lesquels :
- les figures 1 à 3 représentent des calculateurs électroniques de l'art antérieur ;
- la figure 4 est un schéma simplifié d'un calculateur électronique selon l'invention ;
- la figure 5a représente un calculateur électronique selon l'invention ;
- la figure 5b est une vue agrandie d'une carte de 'fond de panier' de la figure 5 ;
- les figures 6 et 7 sont des schémas simplifiés d'exemples de cartes de fond de panier selon l'invention ;
- la figure 8 est un schéma détaillé de la carte de fond de panier de la figure 7 ;
- la figure 9 représente un calculateur dans la plan de la carte de fond de panier ;
- la figure 10 représente un calculateur dans le plan transversal au plan de la carte de fond de panier ;
- la figure 11 illustre le mode de réalisation de deux métallisations coaxiales formant un condensateur et deux inductances et, en final, un réseau filtrant passe-bas assurant une fonction de filtrage du bruit électromagnétique ;
- la figure 12 illustre le procédé de fabrication d'une carte électronique de fond de panier selon l'invention ;
- la figure 13 illustre une carte électronique de fond de panier selon l'invention ;
- les figures 14 et 15 illustrent le procédé de fabrication des trous traversants selon l'invention.

### DESCRIPTION DETAILLEE DE L'INVENTION

En référence à la figure 4, un calculateur électronique 1 comporte un bâti mécanique 11, une ou plusieurs cartes électroniques 12 maintenues mécaniquement dans le bâti 11 et une carte électronique dite carte de 'fond de panier' 20 ou 'backplane' en anglais qui constitue le fond du bâti mécanique 11.

### Bâti mécanique 11

En référence à la figure 4, le bâti mécanique 11 est typiquement un parallélépipède rectangle comportant deux faces parallèles ouvertes : une première face ouverte adaptée pour l'introduction des cartes électroniques 12 et une deuxième face ouverte adaptée pour être fermée par la carte de 'fond de panier' 20. Les cartes électroniques 12 sont maintenues mécaniquement dans le bâti 11 par exemple par des glissières.

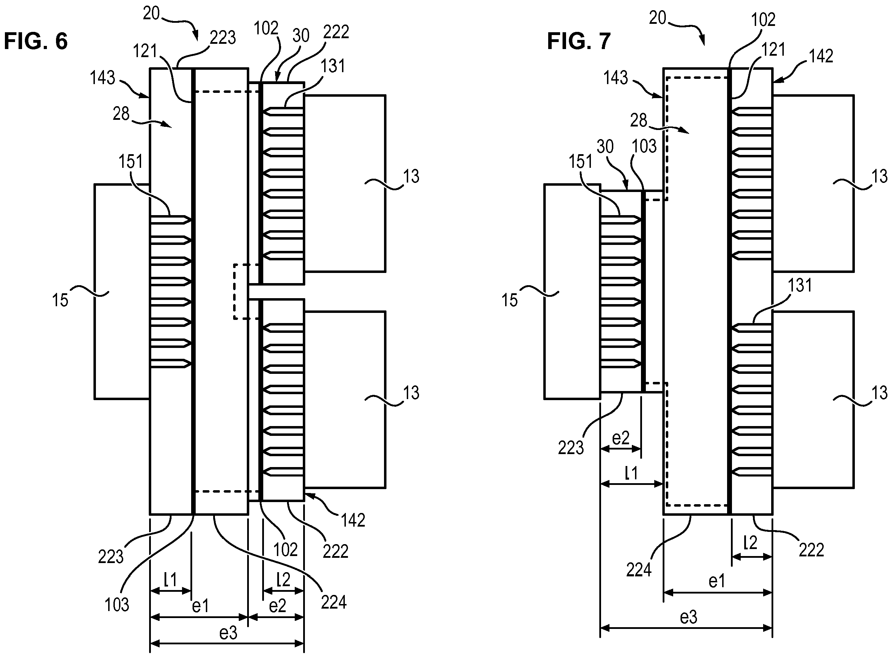

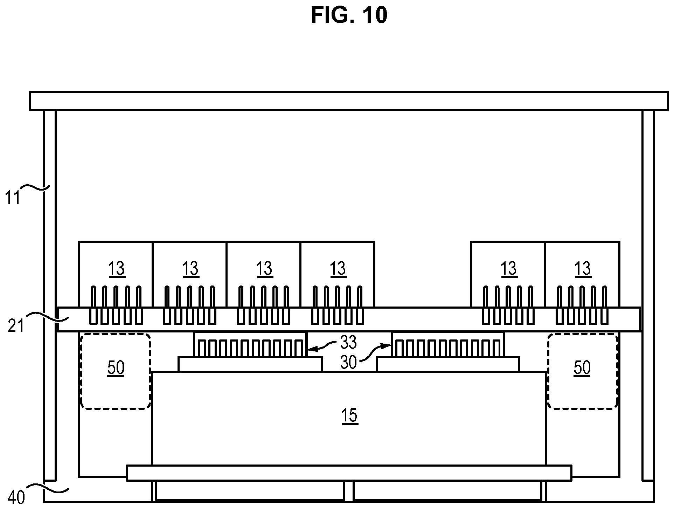

En référence aux figures 6 et 7, la carte de fond de panier 20 (figure 4) est constituée d'un circuit principal 28 dont les dimensions correspondent à la face ouverte du bloc fond. La carte de fond de panier 20 est fixée par sa périphérie sur les flancs du bâti mécanique 11. En référence à la figure 10, le calculateur peut également comporter un support 40 de carte de fond de panier fixé au bâti mécanique 11 sur lequel est fixée la carte de fond de panier 20.

### Carte de fond de panier 20

La carte de fond de panier 20 est adaptée pour être fixée sur le bâti mécanique 11 de manière à fermer la deuxième face ouverte du bâti.

En référence à la figure 7, la carte de fond de panier 20 comporte au moins un circuit imprimé principal 28 sur lequel des pistes forment un ensemble d'interconnexions.

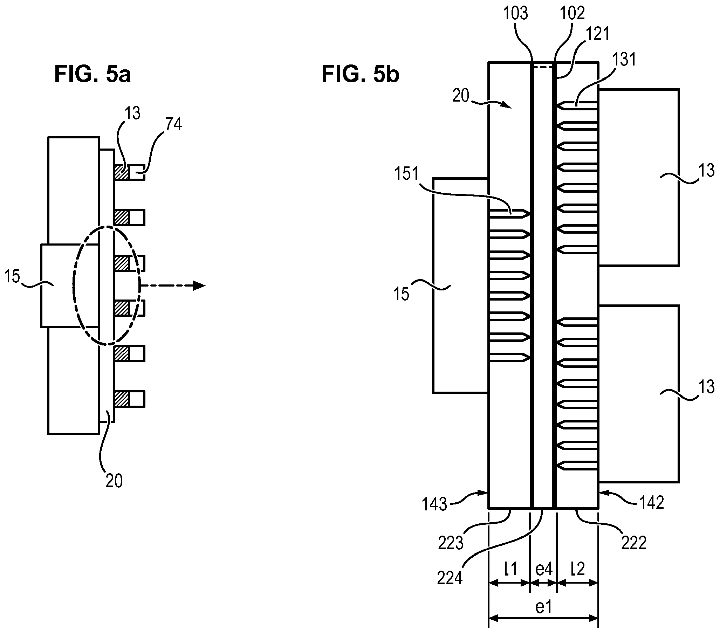

En référence à la figure 5b, la carte de fond de panier 20 présente une face interne 142 adaptée pour recevoir les connecteurs de carte 13 et une face externe 143 adaptée pour recevoir le connecteur externe 15.

La carte de fond de panier 20 comporte :
- un premier circuit imprimé 222 présentant une première face et une seconde face destinée à former la face interne 142 de la carte électronique de fond de panier 20 ;
- un second circuit imprimé 223 présentant une première face et une seconde face destinée à former la face externe 143 de la carte électronique de fond de panier 20 et ;
- un troisième circuit imprimé 224.

La première face du premier circuit imprimé 222 est fixée sur une des faces du troisième circuit imprimé 224, et la première face du second circuit imprimé 223 est fixée sur l'autre face du troisième circuit imprimé 224, avec une résine, typiquement une résine epoxy.

### Carte électronique 12

Chaque carte électronique 12 comprend un circuit imprimé et des composants électroniques.

Chaque carte électronique 12 est connectée au moyen d'un ou de plusieurs connecteurs de carte 13 sur la face interne 142 de la carte électronique de fond de panier 20.

Les connecteurs de carte 13 présentent des éléments de connexion à insertion par force 131 qui sont typiquement des éléments de connexion en forme de broche. Ces éléments de connexion en forme de broche ont typiquement une longueur l2 comprise entre 1 et 2,5 mm.

### Connecteur externe de type ARINC 600 15

Un ou plusieurs modules de pilotage sont connectés à la carte de fond de panier 20 de manière à communiquer avec le bus de celle-ci selon un protocole de bus série distribués par exemple de types ARINC 429.

Chaque module de pilotage est constitué d'une ou plusieurs cartes adaptées pour être connectée sur la face externe 143 de la carte de fond de panier 20 par un connecteur externe 15 par exemple un connecteur de type ARINC 600.

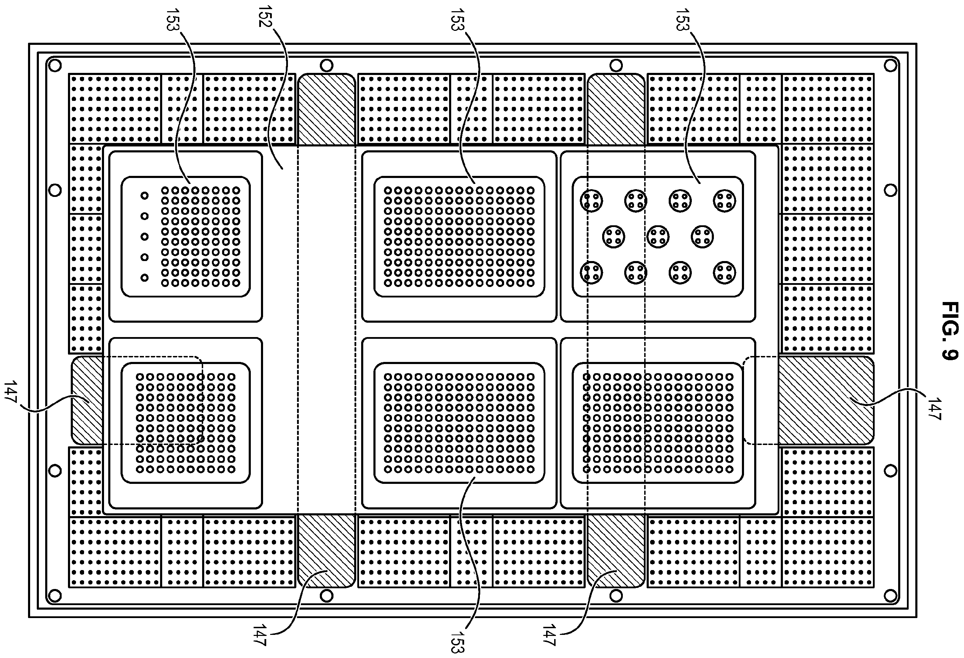

Le connecteur externe 15 comporte une emprise 152 (figure 9) comportant des empreintes de connecteur 153 présentant des éléments de connexion à insertion par force 151 qui sont typiquement des éléments de connexion en forme de broche. Ces éléments de connexion en forme de broche 151 (figure 5b) ont typiquement une longueur l1 comprise entre 1 et 2,5 mm.

### Trous borgnes

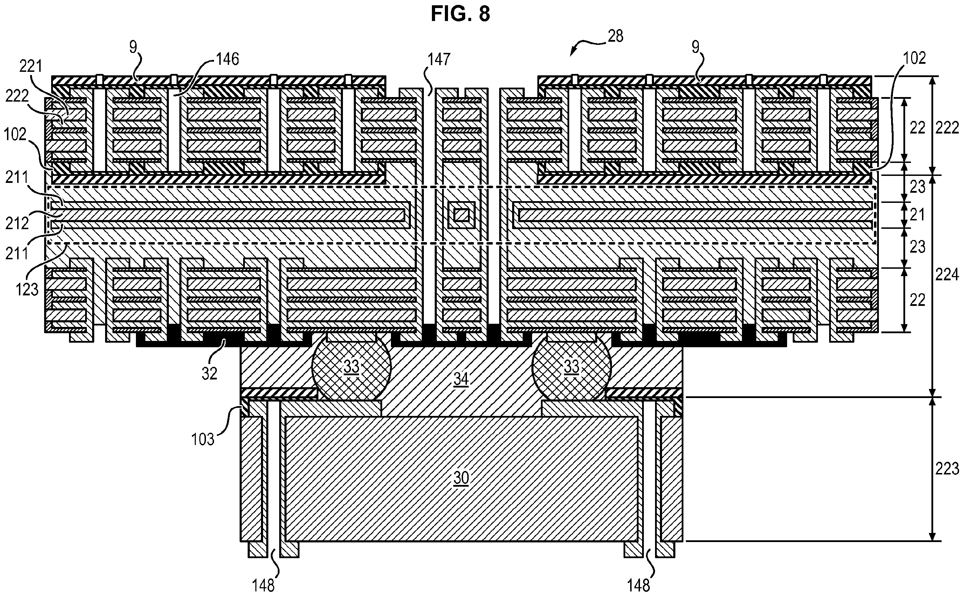

En référence aux figures 5b et 8, la carte de fond de panier 20 possède des premiers trous borgnes 146 débouchant sur sa face interne 142 et adaptés pour recevoir des éléments de connexion à insertion par force portés par les connecteurs de carte 13, et des seconds trous 148 débouchant sur sa face externe 143 et adaptés pour recevoir des éléments de connexion à insertion par force portés par les connecteurs externe 15.

Les seconds trous 148 sont initialement traversant, mais après assemblage, ils sont borgnes.

Les trous 146 et 148 ne traversent pas la carte de fond de panier de part et d'autre.

Les trous 146 et 148 sont coaxiaux et perpendiculaires au plan de la carte de fond de panier 20.

Les trous 146 et 148 sont métallisés et permettent d'établir une liaison électrique entre les différents couches conductrice d'un même circuit imprimé multicouche 22. La métallisation des trous consiste, une fois le trou percé, à déposer une fine couche de cuivre à l'intérieur du trou, par un procédé de dépôt de cuivre par électrolyse. Une fois métallisé, le trou fait la connexion électrique entre les couches qu'il traverse.

Les premiers trous borgnes 146 sont avantageusement recouverts d'une couche externe 9 de polymère isolant tel que du polyimide type Kapton^{®} (polyimide de Dupont de Nemours). Cette couche est destinée à être percée par les connecteurs en forme de broches 131 lors du montage des connecteurs de carte 13 (figure 5b). Elle permet de protéger les trous borgnes 146 de toute pollution avant le montage des connecteurs de cartes 13 et notamment des agents polluants qui viennent de la métallisation des trous traversant 147.

### Trous métallisés traversants

La carte de fond de panier 20 possède des trous traversants 147 qui traversent la carte de fond de panier 20 de part et d'autre. Les trous traversants 147 sont métallisés et permettent d'établir une connexion électrique entre l'ensemble des couches conductrices.

Les trous traversants 147 sont coaxiaux et perpendiculaires au plan de la carte de fond de panier 20.

Les deux couches conductrices 211 sont connectées entre elles par une couche métallique cylindrique 129.

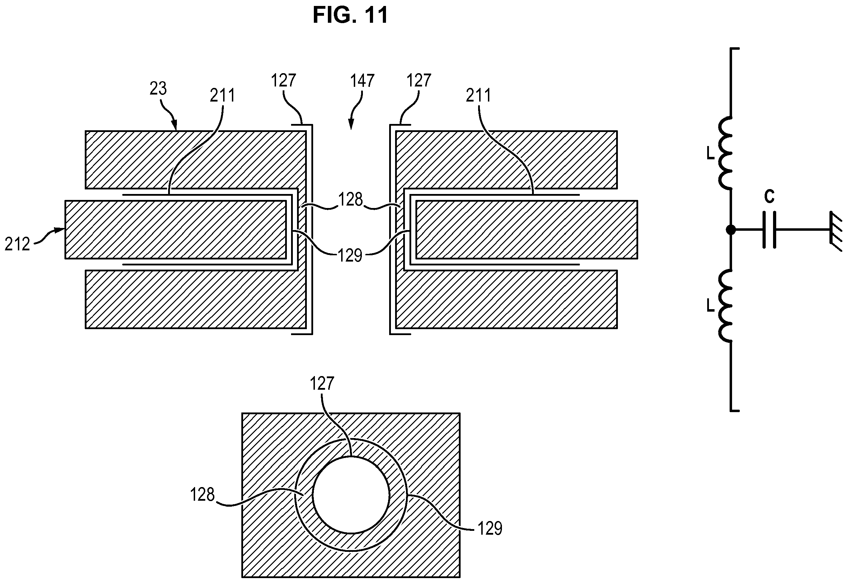

En référence à la figure 11, la paroi métallique du trou traversant métallisé 147, les deux couches conductrices 211 reliées à deux équipotentiels, et la couche métallique cylindrique 129 forment ensemble un réseau filtrant passe-bas assurant une fonction de filtrage du bruit électromagnétique. En effet, la paroi métallique du trou traversant métallisé 147 forme avec la couche conductrice 129 une capacité, tandis que les parties de métallisation du trou 147 émergent des deux couches conductrices 211 forment deux inductances.

### Eléments de connexion à insertion par force 131 et 151

Les éléments de connexion à insertion par force 131 portés par les connecteurs de carte 13 et les éléments de connexion à insertion par force 151 portés par le connecteur externe 15 sont adaptés pour être insérés à force dans un des trous borgnes 146 de la carte de fond de panier 20 de manière à former une jonction électrique à insertion par force dite 'press-fit' avec le trou borgne, assurant l'interconnexion mécanique et électrique.

Une fois l'élément de connexion à insertion par force 131 ou 151 inséré dans un trou 146 ou 148, ils constituent ensemble un point de connexion.

Lorsqu'un élément de contact en forme de broches 131 et 151 est enfoncé dans un trou 146 ou 148, l'élément de contact en forme de broche 131 et 151 et/ou les trous 146 et 148 se déforment de manière élastique lors de l'insertion, de manière à créer une force de friction entre les deux.

A cet effet, les éléments de contact en forme de broche 131 et 151 présentent des propriétés d'élasticité en compression. Les broches 131 et 151 comprennent une partie d'ajustement par pression adaptée pour être mis en contact avec une surface interne des trous 146 et 148 du circuit imprimé. La partie d'ajustement par pression comprend un mécanisme à ajustement serré adapté pour être déformé élastiquement lors de l'insertion dans les trous 146 et 148. Ce mécanisme à ajustement serré comprend typiquement une saillie et un évidement complémentaire comme par exemple un bossage ou une fente en forme de 'chat d'aiguille' au centre de l'axe longitudinal de la broche.

Alternativement ou en complément les trous 146 et 148 présentent des propriétés d'élasticité.

Le diamètre des trous 146 et 148 est légèrement plus petit que la largeur de la broche, de manière à ce que l'insertion crée une force de frottement.

Les trous 146 et 148 ont typiquement une forme cylindrique.

Pour améliorer l'insertion et le maintien des broches dans les trous 146 et 148, les trous 146 et 148 présentent avantageusement un diamètre diminuant dans une direction orientée de l'intérieur de la carte électronique à la surface de la carte électronique. Les trous 146 et 148 ont par exemple une forme tronconique.

Une première membrane étanche 102 est disposée entre le premier circuit imprimé 222 et le troisième circuit imprimé 224 ;
Une seconde membrane étanche 103 est disposée entre le second circuit imprimé 223 et le troisième circuit imprimé 224.

Par étanche on entend qu'elle ne laisse pas passer la résine.

Les premiers trous borgnes 146 débouchent d'une part sur la face interne 142 de la carte électronique de fond de panier 20 et d'autre part sur la première membrane étanche 102.

Les seconds trous borgnes 148 débouchent d'une part sur la face externe 143 de la carte électronique de fond de panier 20 et d'autre part sur la seconde membrane étanche 103,
Les membranes étanches 102 et 103 permettent d'éliminer le risque de pollution des trous borgnes lors de la fabrication en empêchant la remontée de résine lors de l'assemblage des circuits imprimés 22, 223 et 224.

Les membranes étanches 102 et 103 sont dans un matériau qui est typiquement en polymère isolant tel que du polyimide type Kapton^{®} (polyimide de Dupont de Nemours).

Les membranes étanches 102 et 103 sont dans un matériau présentant une dureté supérieure ou égale à, celle du Kapton^{®} soit une dureté Rockwell supérieure ou égale à E52-99, la dureté Rockwell étant définie comme la résistance qu'oppose une surface de l'échantillon à la pénétration d'une bille d'acier de 1,588 mm de diamètre, une unité de dureté Rockwell correspond à un enfoncement de 0,001 mm.

Le circuit imprimé principal 28 comporte un circuit imprimé double faces 21 disposé au milieu de deux couches isolantes 23 elles-mêmes disposées au milieu de deux circuits imprimés multicouches 22. Les circuits imprimés multicouches 22 comportent des pistes pour le routage de signaux entre les différents points de connexion et définissent une zone de routage pour le routage des signaux.

On appelle classiquement la zone interne au calculateur la zone propre et la zone externe au calculateur la zone sale car celle-ci est polluée par toute sorte d'émissions électromagnétiques externes. La présence d'un circuit imprimé double faces 21 et des deux couches isolantes 23 permet d'améliorer l'isolation entre la zone sale et la zone propre.

Le circuit imprimé double faces 21 comporte deux couches conductrices 211 reliées à deux équipotentiels disposées de part et d'autre d'une couche isolante centrale 212 en prépreg. Les deux couches conductrices 211 reliées à deux équipotentiels disposées de part et d'autre d'une couche isolante centrale 212, typiquement en prépreg constitué par exemple d'un tissu préimprégné de résine, constituent une zone de blindage 121 efficace pour ségréger la zone propre de la zone sale.

Lorsque la carte de fond de panier 20 comporte un circuit imprimé principal 28 comportant deux circuits imprimés multicouches 22, deux couches isolantes 23, et un circuit imprimé double faces 21 disposé au milieu des deux couches isolantes 23, elles-mêmes disposées au milieu des deux circuits imprimés multicouches 22, le circuit imprimé double faces 21 constituant la zone de blindage 121, la première membrane 102 est disposée entre le circuit imprimé multicouche 22, et l'une des couches isolantes 23, et la seconde membrane 103 est disposée entre le circuit imprimé multicouche 22 et l'autre couche isolante 23.

Les circuits imprimés multicouches 22 comportant plusieurs couches conductrices 221, séparées chacune par des couches isolantes 222 typiquement en résine epoxy.

Les trous métallisés borgnes 146 traversent l'un des circuits imprimé multicouche 22 mais pas le circuit imprimé double face 21. Les trous métallisés borgnes 146 permettent d'établir une liaison électrique entre les différents couches conductrice d'un même circuit imprimé multicouche 22.

Les trous métallisés traversants 147 traversent les deux circuits imprimés multicouches 22 et le circuit imprimé double faces 21. Les trous métallisés traversants permettent d'établir une connexion électrique entre l'ensemble des couches conductrices.

### Plaquettes d'interface 30

Dans un mode de réalisation particulier, pour résoudre le problème de son épaisseur insuffisante pour l'accueil simultané dans le même circuit imprimé des broches 131 et 135 de part et d'autre, la carte de fond de panier 20 est épaissie artificiellement en fixant des plaquettes d'interface 30 sur le circuit imprimé principal 28 sous les connecteurs à rehausser.

Une plaquette d'interface 30 peut être fixée sur la face externe 143 de la carte de fond de panier sous un connecteur externe 15, comme illustré en figure 7, ou sur la face interne 142 de la carte de fond de panier sous un connecteur de carte 13, comme illustré en figure 6.

En référence à la figure 5b, lorsque les éléments en forme de broches 131 (respectivement 151) ont une longueur l1 (respectivement l2) de l'ordre de 1.5mm, la carte de fond de panier 20 a typiquement une épaisseur e1 de 3mm, et la plaquette d'interface 30 une épaisseur e2 de 2mm, l'épaisseur totale e3 de la carte de fond de panier 20 étant donc de 5mm, ce qui correspond à la limite haute de faisabilité en mode standard.

En référence à la figure 5b, lorsque les éléments en forme de broches 131 (respectivement 151) ont une longueur l1 (respectivement l2) de l'ordre de 3.7mm, la carte de fond de panier 20 a typiquement une épaisseur e1 de 5mm, et la plaquette d'interface 30 une épaisseur e2 de 4mm, l'épaisseur totale e3 de la carte de fond de panier 20 étant donc de 10mm.

En référence à la figure 8, les plaquettes d'interface 30 comportent un circuit imprimé typiquement double face dans lequel sont ménagées des trous 148 identiques aux trous borgnes 146 adaptés pour recevoir des éléments de connexion à insertion par force. Ces trous 148 peuvent aussi être des trous traversants bouchés par un film isolant.

En référence à la figure 8, les plaquettes d'interface 30 comportent en outre, sur la face opposée à celle sur laquelle débouchent les trous 148, des moyens de fixation 33 au circuit imprimé principal 28. Ces moyens de fixation 33 sont par exemple une matrice de billes 33 (en anglais Ball Grid Array ou BGA) destinée à être soudée sur le circuit imprimé principal 28 qui présente alors des plages d'accueil d'un diamètre adéquat. La cohésion mécanique entre les plaquettes d'interface 30 et le circuit imprimé principal 28 peut en outre être assurée par collage à l'aide d'une couche adhésif isolant 34 tel qu'une colle époxy fluant par capillarité (appelé 'underfill' selon la terminologie anglo-saxonne).

En référence à la figure 8, une couche de fermeture 32 typiquement en résine epoxy peut être avantageusement ajoutée entre la couche adhésif isolant 34 et le circuit imprimé principal 28 pour empêcher la remontée de la couche adhésif isolant 34 dans les trous traversants 147.

L'épaisseur de la carte de fond de panier 20 est déterminée par quatre contraintes majeures :
- la longueur des broches de contact 131 et 135 ;
- l'épaisseur de la zone de blindage 121 ;
- le besoin de symétrie par rapport à la zone de blindage 121.

L'épaisseur de la carte de fond de panier 20 doit être suffisante pour permettre l'accueil des broches de connecteurs 131 et 135 de part et d'autre de la carte de fond de panier.

En outre, la zone de blindage 121 doit être positionnée au milieu de la carte de fond de panier 20 pour assurer sa fonction de blindage électromagnétique. Ainsi, les broches de contact 131 des cartes doivent avoir la même longueur que celles du connecteur externe 135.

L'épaisseur du circuit imprimé principal 28 est typiquement choisie de manière à ce que l'espace entre les broches de connecteurs 131 et 135 ait une épaisseur e4 d'au moins 1mm.

Dans le cas où la carte de fond de panier 20 comporte un unique circuit imprimé principal 28, celui-ci présentant une épaisseur e1 d'au moins 5mm pour permettre l'accueil en opposition des connecteurs cartes 13 et du connecteur externe 15.

Le circuit imprimé principal 28 peut en outre comporter des fonctions de filtrage du bruit électromagnétique.

Des composants électroniques 50 contribuant à la tenue en environnement électromagnétique du calculateur complet peuvent également être placés dans les espaces laissés libres entre les connecteurs externes et le bâti mécanique 10.

### Procédé de fabrication

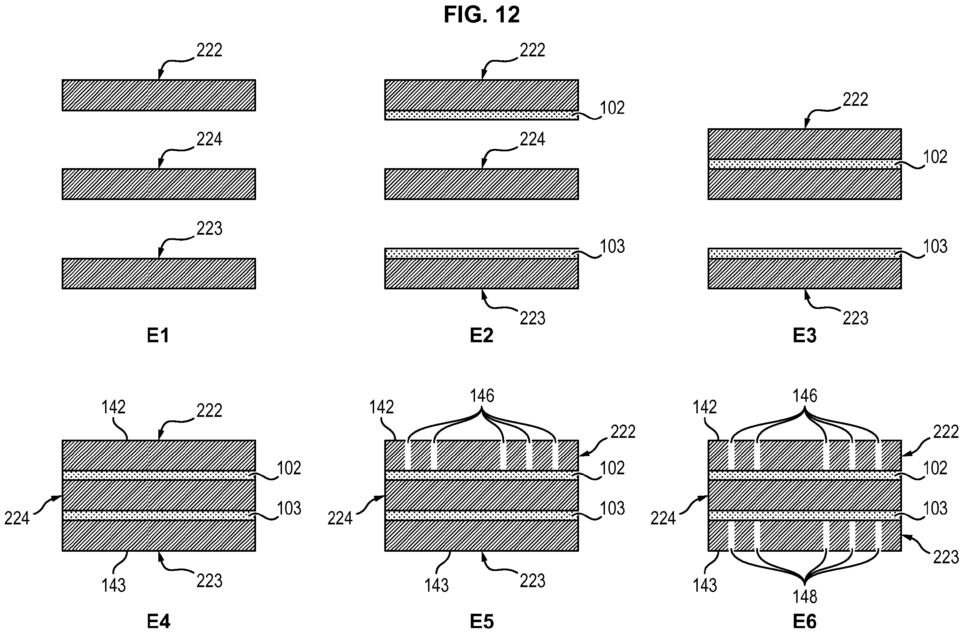

En référence à la figure 12, la carte électronique de fond de panier 20 peut être fabriquée selon un procédé comportant les étapes suivantes :
- E1 fourniture d'un premier circuit imprimé 222 présentant une première face et une seconde face destinée à former la face interne 142 de la carte électronique de fond de panier 20, d'un second circuit imprimé 223 présentant une première face et une seconde face destinée à former la face externe 143 de la carte électronique de fond de panier 20 et d'un troisième circuit imprimé 224 ;
- E2 dépôt sur une première face du premier circuit imprimé 222 d'un film adapté pour se solidifier et former une première membrane 102 et dépôt sur une première face du second circuit imprimé 223 d'un film adapté pour se solidifier et former une seconde membrane 103 ;
- E3 fixation de la première face du premier circuit imprimé 222 sur une des faces du troisième circuit imprimé 224 ;
- E4 fixation de la première face du second circuit imprimé 223 sur l'autre face du troisième circuit imprimé 224
- E5 formation dans le premier circuit imprimé 222 d'une série de premiers trous borgnes 146 débouchant d'une part sur la première face du premier circuit imprimé 222, et d'autre part sur la première membrane étanche 102 ;
- E6 formation dans le second circuit imprimé 223 d'une série de seconds trous borgnes 148 débouchant d'une part sur première face du second circuit imprimé 223 et d'autre part sur la seconde membrane étanche 103,
les premiers et les seconds trous borgnes 146, 148 étant adaptés pour recevoir des éléments de connexion à insertion par force et former avec eux un point de connexion électrique.

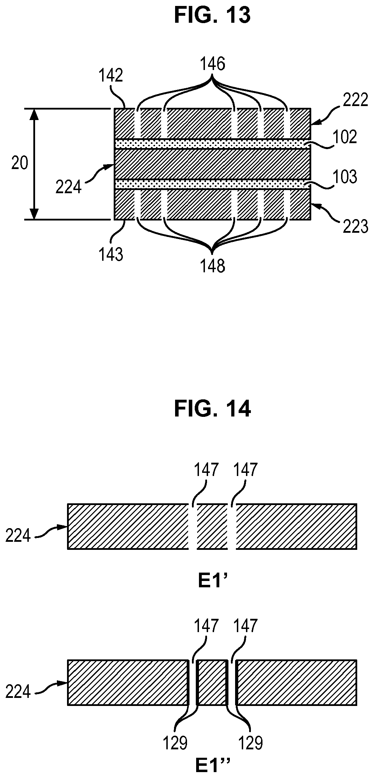

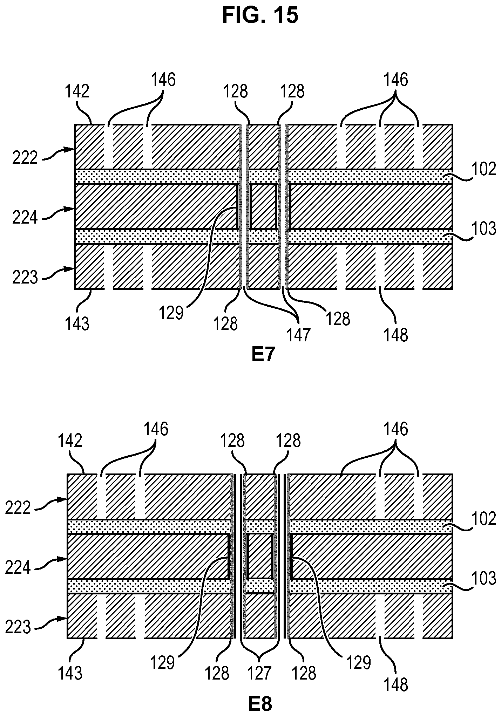

Les trous traversants 147 sont formés de la manière suivante, en référence aux figures 14 et 15, préalablement à l'étape E2 :
- E1' formation dans le troisième circuit imprimé 224 de trous traversants ;
- E1" dépôt d'une première métallisation 129 sur la paroi des trous traversant 147.

Puis, en référence à la figure 15, après les étapes d'assemblage E1 à E6 :
- une étape E7 de perçage de l'ensemble des couches 222, 224 et 223 pour formage des trous 147, coaxiaux des trous métallisés initiaux du circuit 224, remplis de résine lors de la phase d'assemblage.
   Lors de la fixation des circuits imprimés 223 et 222 sur le circuit imprimé 224 à l'aide de la résine, une couche de résine isolante 128 est déposée sur les parois des trous traversants 147.
- E8 dépôt d'une seconde métallisation 127 sur la paroi des trous traversants 147. Cette dernière métallisation forme un couplage capacitif avec la métallisation issue de la jonction entre les couches supérieures et inférieures 211 (fig. 11) du circuit imprimé double face 224.

Le calculateur électronique 1 peut notamment être fabriqué par le procédé de fabrication suivant.

Dans une première étape, les plaquettes d'interface 30 sont soudées à la carte de fond de panier 20. Les plaquettes d'interface 30 présentant des trous 148 traversants. Après fixation des plaquettes d'interface 30 sur la carte de fond de panier 20, les trous 148 sont borgnes.

Dans une seconde étape, la couche d'adhésif isolant 34 est ajoutée sous les cartes d'interface du connecteur externe 15.

Dans une troisième étape, les connecteurs de cartes 13 sont montés par insertion à force sur la face interne de la carte de fond de panier 20.

Dans une quatrième étape, le connecteur externe 15 est monté par insertion à force sur la face externe de la carte de fond de panier 20.

Dans une cinquième étape, la carte de fond de panier 20 est fixée mécanique sur le bâti mécanique 11 du bloc fond.

## Revendications

1. Carte électronique de fond de panier (20) présentant une face interne (142) adaptée pour être connectée à des connecteurs (13) de cartes électroniques (12) et une face externe (143) adaptée pour être connectée à un connecteur externe (15), la carte de fond de panier (20) présentant une première membrane étanche (102), une série de premiers trous borgnes (146) débouchant d'une part sur la face interne (142) de la carte électronique de fond de panier (20) et d'autre part sur la première membrane étanche (102), et une seconde membrane étanche (103), une série de seconds trous borgnes (148) débouchant d'une part sur la face externe (143) de la carte électronique de fond de panier (20) et d'autre part sur la seconde membrane étanche (103), les premiers et les seconds trous borgnes (146, 148) étant adaptés pour recevoir des éléments de connexion à insertion par force et former avec eux un point de connexion électrique, la carte électronique de fond de panier (20) étant **caractérisée en ce qu'**elle comporte deux couches conductrices (211) reliées à deux équipotentiels disposées de part et d'autre d'une couche isolante centrale (212), les deux couches conductrices (211) étant connectées entre elles par une couche métallique cylindrique (129), et possédant en outre des trous traversants métallisés (147) qui traversent la carte de fond de panier (20) de part et d'autre, les trous traversants métallisés (147), la couche métallique cylindrique (129), et les deux couches conductrices (211) formant une traversée capacitive et donc un réseau filtrant passe-bas assurant une fonction de filtrage du bruit électromagnétique.

2. Carte électronique de fond de panier (20) selon la revendication précédente, comportant :
- un premier circuit imprimé (222) présentant une face destinée à former la face interne (142) de la carte électronique de fond de panier (20) ;
- un second circuit imprimé (223) présentant une face destinée à former la face externe (143) de la carte électronique de fond de panier (20) et ;
- un troisième circuit imprimé (224) ;
- la première membrane étanche (102) étant disposée entre le premier circuit imprimé (222) et le troisième circuit imprimé (224) ;
- la seconde membrane étanche (103) étant disposée entre le second circuit imprimé (223) et le troisième circuit imprimé (224).

3. Carte de fond de panier (20) selon l'une des revendications précédentes, comportant un circuit imprimé principal (28) comportant deux circuits imprimés multicouches (22), deux couches isolantes (23), et un circuit imprimé double faces (21) disposé au milieu des deux couches isolantes (23), elles-mêmes disposées au milieu des deux circuits imprimés multicouches (22), le circuit imprimé double faces (21) constituant la zone de blindage (121).

4. Carte de fond de panier (20) selon la revendication précédente, dans lequel la première membrane (102) est disposée entre le circuit imprimé multicouche (22), et l'une des couches isolantes (23).

5. Carte de fond de panier (20) selon l'une des revendications précédentes, comportant un circuit imprimé principal (28) et une plaquette d'interface (30) fixée sur le circuit imprimé principal (28), la plaquette d'interface (30) présentant des trous (148) adaptés pour recevoir des éléments de connexion à insertion par force et former avec eux un point de connexion électrique.

6. Carte de fond de panier (20) selon la revendication précédente, la plaquette d'interface (30) comportant une matrice de billes (33) adaptée pour être soudée sur le circuit imprimé principal (28).

7. Carte de fond de panier (20) selon l'une des revendications précédentes, les premiers trous borgnes (146) étant avantageusement recouverts d'une troisième membrane étanche (9) destinée à protéger les trous métallisés et à être percée par des éléments de connexion à insertion par force.

8. Carte de fond de panier (20) selon l'une des revendications précédentes, dans lequel les membranes étanches (102, 103, 9) sont des films de polyimide.

9. Calculateur électronique (1) comportant un bâti mécanique (11), une carte de fond de panier (20) selon l'une des revendications précédentes, un ou plusieurs connecteurs de cartes électroniques (12) connectés à la carte de fond de panier (20) sur sa face interne (142), et au moins un connecteur externe (15) connecté à la carte de fond de panier (20) sur sa face externe (143).

10. Procédé de fabrication d'une carte électronique de fond de panier (20) selon l'une des revendications 1 à 8, comportant les étapes suivantes :
- (E1) fourniture d'un premier circuit imprimé (222) présentant une première face et une seconde face destinée à former la face interne (142) de la carte électronique de fond de panier (20), d'un second circuit imprimé (223) présentant une première face et une seconde face destinée à former la face externe (143) de la carte électronique de fond de panier (20) et d'un troisième circuit imprimé (224);
- (E2) dépôt sur la première face du premier circuit imprimé (222) d'un film adapté pour se solidifier et former une première membrane (102) ; et dépôt sur la première face du second circuit imprimé (223) d'un film adapté pour se solidifier et former une seconde membrane (103) ;
- (E3) fixation de la première face du premier circuit imprimé (222) sur une des faces du troisième circuit imprimé (224) ;
- (E4) fixation de la première face du second circuit imprimé (223) sur l'autre face du troisième circuit imprimé (224)
- (E5) formation dans le premier circuit imprimé (222) d'une série de premiers trous borgnes (146) débouchant d'une part sur la face interne (142) de la carte électronique de fond de panier (20), et d'autre part sur la première membrane étanche (102) ;
- (E6) formation dans le second circuit imprimé (223) d'une série de seconds trous borgnes (148) débouchant d'une part sur la face externe (143) de la carte électronique de fond de panier (20), et d'autre part sur la seconde membrane étanche (103).

11. Procédé de fabrication selon la revendication 10, comportant en outre les étapes suivantes :
avant l'étape (E2) :
- (E1') formation dans le troisième circuit imprimé (224) de trous traversants (147) ;
- (E1") dépôt d'une première métallisation (129) sur la paroi des trous traversants (147) ;
au cours des étapes (E3) et (E4), le premier circuit imprimé (222) est fixé sur le troisième circuit imprimé (224) et le second circuit imprimé (223) sur le troisième circuit imprimé (224) par de la résine isolante, la résine isolante formant une couche isolante (128) sur la paroi des trous traversants (147) ;
- (E7) formation dans le premier circuit imprimé (222) et le deuxième circuit imprimé (223) de trous traversants (147) communiquant avec ceux formés dans le troisième circuit imprimé (224) ;
- (E8) dépôt d'une seconde métallisation (127) sur la couche isolante (128) recouvrant la paroi des trous traversants (147).

## Patentansprüche

1. Backplane-Leiterplatte (20), die eine Innenseite (142), die dazu geeignet ist, mit Verbindern (13) von Leiterplatten (12) verbunden zu werden, und eine Außenseite (143) aufweist, die dazu geeignet ist, mit einem externen Verbinder (15) verbunden zu werden, wobei die Backplane-Leiterplatte (20) eine erste dichte Membran (102), wobei eine Reihe von ersten Sacklöchern (146) einerseits auf der Innenseite (142) der Backplane-Leiterplatte (20) und andererseits auf der ersten dichten Membran (102) münden, und eine zweite dichte Membran (103) aufweist, wobei eine Reihe von zweiten Sacklöchern (148) einerseits auf der Außenseite (143) der Backplane-Leiterplatte (20) und andererseits auf der zweiten dichten Membran (103) münden, wobei die ersten und die zweiten Sacklöcher (146, 148) dazu geeignet sind, Verbindungselemente mit kraftschlüssiger Einsetzung aufzunehmen und mit ihnen einen elektrischen Verbindungspunkt zu bilden, wobei die Backplane-Leiterplatte (20) **dadurch gekennzeichnet ist, dass** sie zwei leitfähige Schichten (211) umfasst, die an zwei Äquipotentiale angeschlossen sind, die auf beiden Seiten einer mittleren isolierten Schicht (212) angeordnet sind, wobei die zwei leitfähigen Schichten (211) untereinander durch eine zylindrische metallische Schicht (129) verbunden sind und ferner metallisierte Durchgangslöcher (147) besitzen, die die Backplane-Leiterplatte (20) auf beiden Seiten durchqueren, wobei die metallisierten Durchgangslöcher (147), die zylindrische metallische Schicht (129) und die zwei leitfähigen Schichten (211) eine kapazitive Durchführung und somit ein Tiefpassfilternetz bilden, das eine Funktion zur Filterung von elektromagnetischem Rauschen gewährleistet.

2. Backplane-Leiterplatte (20) nach dem vorhergehenden Anspruch, die umfasst:
- eine erste gedruckte Schaltung (222), die eine Seite aufweist, die dazu bestimmt ist, die Innenseite (142) der Backplane-Leiterplatte (20) zu bilden;
- eine zweite gedruckte Schaltung (223), die eine Seite aufweist, die dazu bestimmt ist, die Außenseite (143) der Backplane-Leiterplatte (20) zu bilden; und
- eine dritte gedruckte Schaltung (224);
- wobei die erste dichte Membran (102) zwischen der ersten gedruckten Schaltung (222) und der dritten gedruckten Schaltung (224) angeordnet ist;
- wobei die zweite dichte Membran (103) zwischen der zweiten gedruckten Schaltung (223) und der dritten gedruckten Schaltung (224) angeordnet ist.

3. Backplane-Leiterplatte (20) nach einem der vorhergehenden Ansprüche, die eine gedruckte Hauptschaltung (28) umfasst, die zwei mehrschichtige gedruckte Schaltungen (22), zwei isolierende Schichten (23) und eine doppelseitige gedruckte Schaltung (21) umfasst, die in der Mitte der zwei isolierenden Schichten (23) angeordnet ist, die selbst in der Mitte der zwei mehrschichtigen gedruckten Schaltungen (22) angeordnet sind, wobei die doppelseitige gedruckte Schaltung (21) die Abschirmungszone (121) bildet.

4. Backplane-Leiterplatte (20) nach dem vorhergehenden Anspruch, wobei die erste Membran (102) zwischen der mehrschichtigen gedruckten Schaltung (22) und einer der isolierenden Schichten (23) angeordnet ist.

5. Backplane-Leiterplatte (20) nach einem der vorhergehenden Ansprüche, die eine gedruckte Hauptschaltung (28) und eine Schnittstellenplatte (30) umfasst, die an der gedruckten Hauptschaltung (28) befestigt ist, wobei die Schnittstellenplatte (30) Löcher (148) aufweist, die dazu geeignet sind, Verbindungselemente mit kraftschlüssiger Einsetzung aufzunehmen und mit ihnen einen elektrischen Verbindungspunkt zu bilden.

6. Backplane-Leiterplatte (20) nach dem vorhergehenden Anspruch, wobei die Schnittstellenplatte (30) eine Kugelgitteranordnug (33) umfasst, die dazu geeignet ist, an die gedruckte Hauptschaltung (28) geschweißt zu werden.

7. Backplane-Leiterplatte (20) nach einem der vorhergehenden Ansprüche, wobei die ersten Sacklöcher (146) vorzugsweise mit einer dritten dichten Membran (9) bedeckt sind, die dazu bestimmt ist, die metallisierten Löcher zu schützen und von Verbindungselementen mit kraftschlüssiger Einsetzung durchbohrt zu werden.

8. Backplane-Leiterplatte (20) nach einem der vorhergehenden Ansprüche, wobei die dichten Membranen (102, 103, 9) Polyimid-Filme sind.

9. Elektronischer Rechner (1), der ein mechanisches Gestell (11), eine Backplane-Leiterplatte (20) nach einem der vorhergehenden Ansprüche, einen oder mehrere Leiterplattenverbinder (12), die mit der Backplane-Leiterplatte (20) auf ihrer Innenseite (142) verbunden sind, und mindestens einen äußeren Verbinder (15) umfasst, der mit der Backplane-Leiterplatte (20) auf ihrer Außenseite (143) verbunden ist.

10. Verfahren zur Herstellung einer Backplane-Leiterplatte (20) nach einem der Ansprüche 1 bis 8, das die folgenden Schritte umfasst:
- (E1) Bereitstellen einer ersten gedruckten Schaltung (222), die eine erste Seite und eine zweite Seite aufweist, die dazu bestimmt ist, die Innenseite (142) der Backplane-Leiterplatte (20) zu bilden, einer zweiten gedruckten Schaltung (223), die eine erste Seite und eine zweite Seite aufweist, die dazu bestimmt ist, die Außenseite (143) der Backplane-Leiterplatte (20) zu bilden, und einer dritten gedruckten Schaltung (224);
- (E2) Aufbringen eines Films, der dazu geeignet ist, sich zu verfestigen und eine erste Membran (102) zu bilden, auf der ersten Seite der ersten gedruckten Schaltung (222); und Aufbringen eines Films, der dazu geeignet ist, sich zu verfestigen und eine zweite Membran (103) zu bilden, auf der ersten Seite der zweiten gedruckten Schaltung (223);
- (E3) Befestigen der ersten Seite der ersten gedruckten Schaltung (222) auf einer der Seiten der dritten gedruckten Schaltung (224);
- (E4) Befestigen der ersten Seite der zweiten gedruckten Schaltung (223) auf der anderen Seite der dritten gedruckten Schaltung (224);
- (E5) Bilden einer Reihe von ersten Sacklöchern (146), die einerseits auf der Innenseite (142) der Backplane-Leiterplatte (20) und andererseits auf der ersten dichten Membran (102) münden, in der ersten gedruckten Schaltung (222);
- (E6) Bilden einer Reihe von zweiten Sacklöchern (148), die einerseits auf der Außenseite (143) der Backplane-Leiterplatte (20) und andererseits auf der zweiten dichten Membran (103) münden, in der zweiten gedruckten Schaltung (223).

11. Herstellungsverfahren nach Anspruch 10, das ferner die folgenden Schritte umfasst:
vor dem Schritt (E2):
- (E1') Bilden von Durchgangslöchern (147) in der dritten gedruckten Schaltung (224);
- (E1") Aufbringen einer ersten Metallisierung (129) auf der Wand der Durchgangslöcher (147);
während der Schritte (E3) und (E4) werden die erste gedruckte Schaltung (222) an der dritten gedruckten Schaltung (224) und die zweite gedruckte Schaltung (223) an der dritten gedruckten Schaltung (224) durch isolierendes Harz befestigt, wobei das isolierende Harz eine isolierende Schicht (128) auf der Wand der Durchgangslöcher (147) bildet;
- (E7) Bilden von Durchgangslöchern (147), die mit denjenigen verbunden sind, die in der dritten gedruckten Schaltung (224) gebildet sind, in der ersten gedruckten Schaltung (222) und der zweiten gedruckten Schaltung (223) ;
- (E8) Aufbringen einer zweiten Metallisierung (127) auf der isolierenden Schicht (128), die die Wand der Durchgangslöcher (147) bedeckt.

## Claims

1. A backplane electronic board (20) having an internal face (142) adapted for being connected to connectors (13) of electronic boards (12) and an external face (143) adapted for being connected to an external connector (15), the backplane board (20) having a first leak-proof membrane (102), a series of first blind holes (146) opening on the one hand on the internal face (142) of the backplane electronic board (20) and on the other hand on the first leak-proof membrane (102), and a second leak-proof membrane (103), a series of second blind holes (148) opening on the one hand on the external face (143) of the backplane electronic board (20) and on the other hand on the second leak-proof membrane (103), the first and the second blind holes (146, 148) being adapted for receiving force-insertion connection elements and forming with them an electric connection point, the backplane electronic board (20) being **characterized in that** includes two conductive layers (211) connected to two equipotentials positioned on either side of a central insulating layer (212), both conductive layers (211) being connected together with a cylindrical metal layer (129), and further having metallized through-holes (147) which cross the backplane board (20) on both sides, the metallized through-holes (147), the cylindrical metal layer (129), and both conductive layers (211) forming a capacitive through-hole and therefore a low-pass filtering network ensuring a function of filtering the electromagnetic noise.

2. The backplane electronic board (20) according to the preceding claim, including:
- a first printed circuit (222) having a face intended to form the internal face (142) of the backplane electronic board (20);
- a second printed circuit (223) having a face intended to form the external face (143) of the backplane electronic board (20) and;
- a third printed circuit (224);
- the first leak-proof membrane (102) being positioned between the first printed circuit (222) and the third printed circuit (224);
- the second leak-proof membrane (103) being positioned between the second printed circuit (223) and the third printed circuit (224).

3. The backplane board (20) according to one of the preceding claims, including a main printed circuit (28) including two multilayer printed circuits (22), two insulating layers (23), and a double face printed circuit (21) positioned in the middle of the two insulating layers (23), themselves positioned in the middle of the two multilayer printed circuits (22), the double face printed circuit (21) forming the shielding area (121).

4. The backplane board (20) according to the preceding claim, wherein the first membrane (102) is positioned between the multilayer printed circuit (22), and one of the insulating layers (23).

5. The backplane board (20) according to one of the preceding claims, including a main printed circuit (28) and an interface platelet (30) attached on the main printed circuit (28), the interface platelet (30) having holes (148) adapted for receiving force-insertion connection elements and forming with them an electric connection point.

6. The backplane board (20) according to the preceding claim, the interface platelet (30) including a matrix of beads (33) adapted for being welded on the main printed circuit (28).

7. The backplane board (20) according to one of the preceding claims, the first blind holes (146) being advantageously covered with a third leak-proof membrane (9) intended to protect the metallized holes and to be pierced by force-insertion connection elements.

8. The backplane board (20) according to one of the preceding claims, wherein the leak-proof membranes (102, 103, 9) are polyimide films.

9. An electronic computer (1) including a mechanical frame (11), a backplane board (20) according to one of the preceding claims, one or several electronic board connectors (12) connected to the backplane board (20) on its internal face (142), and at least one external connector (15) connected to the backplane board (20) on its external face (143).

10. A method for manufacturing a backplane electronic board (20) according to one of claims 1 to 8, including the following steps:
- (E1) providing a first printed circuit (222) having a first face and a second face intended to form the internal face (142) of the backplane electronic board (20), a second printed circuit (223) having a first face and a second face intended to form the external face (143) of the backplane electronic board (20) and a third printed circuit (224);
- (E2) depositing on the first face of the first printed circuit (222) a film adapted for solidifying and forming a first membrane (102); and depositing on the first face of the second printed circuit (223) a film adapted for solidifying and forming a second membrane (103) ;
- (E3) attaching the first face of the first printed circuit (222) on one of the faces of the third printed circuit (224);
- (E4) attaching the first face of the second printed circuit (223) on the other face of the third printed circuit (224);
- (E5) forming in the first printed circuit (222) a series of first blind holes (146) opening on the one hand on the internal face (142) of the backplane electronic board (20), and on the other hand on the first leak-proof membrane (102);
- (E6) forming in the second printed circuit (223) a series of second blind holes (148) opening on the one hand on the external face (143) of the backplane electronic board (20), and on the other hand on the second leak-proof membrane (103).

11. The manufacturing method according to claim 10, further including the following steps:
before step (E2):
- (E1') forming through-holes (147) in the third printed circuit (224);
- (E1") depositing a first metallization (129) on the wall of the through-holes (147);
during steps (E3) and (E4), the first printed circuit (222) is attached onto the third printed circuit (224) and the second printed circuit (223) onto the third printed circuit (224) by insulating resin, the insulating resin forming an insulating layer (128) on the wall of the through-holes (147);
- (E7) forming in the first printed circuit (222) and the second printed circuit (223) through-holes (147) communicating with those formed in the third printed circuit (224);
- (E8) depositing a second metallization (127) on the insulating layer (128) covering the wall of the through-holes (147).
